**Europäisches Patentamt**

**European Patent Office**

**Office européen des brevets**

(19)

(11) Veröffentlichungsnummer : **0 012 859**
**B1**

(12) **EUROPÄISCHE PATENTSCHRIFT**

(45) Veröffentlichungstag der Patentschrift :
07.11.84

(51) Int. Cl.³ : **H 01 L 21/00**

(21) Anmeldenummer : **79104717.8**

(22) Anmeldetag : **27.11.79**

(54) Verfahren zum Aufbringen eines Dünnfilmmusters auf ein Substrat.

(30) Priorität : **29.12.78 US 974461**

(43) Veröffentlichungstag der Anmeldung :
**09.07.80 Patentblatt 80/14**

(45) Bekanntmachung des Hinweises auf die Patenterteilung : **07.11.84 Patentblatt 84/45**

(84) Benannte Vertragsstaaten :
**DE FR GB**

(56) Entgegenhaltungen :
FR-A- 2 310 633
US-A- 3 873 361
US-A- 3 985 597
US-A- 4 040 891

(73) Patentinhaber : **International Business Machines Corporation**
**Old Orchard Road**
**Armonk, N.Y. 10504 (US)**

(72) Erfinder : **Havas, Janos**
**Larchmont Drive**
**Hopewell Junction, New York 12533 (US)**
Erfinder : **Paal, Gabor**
**P.O. Box 26**
**Fishkill, New York 12524 (US)**

(74) Vertreter : **Busch, Robert, Dipl.-Ing.**
**Schönaicher Strasse 220**
**D-7030 Böblingen (DE)**

EP 0 012 859 B1

**Beschreibung**

Die Erfindung betrifft ein Verfahren, wie es dem Oberbegriff des Anspruchs 1 zu entnehmen ist.

Die Tendenz bei Vakuumniederschlagsverfahren metallischer Dünnfilme geht allgemein dahin, chemische Ätzprozesse unter Benutzung ätzbeständiger Maskenschichten zur Bereitstellung entsprechender Muster anzuwenden, entsprechend üblichen Photogravüre- oder Photolithographie-Ätzverfahren. Bei immer weiter vorangetriebener Miniaturisierung von monolitisch integrierten Halbleiterschaltungen zur Erzielung entsprechend höherer Komponentendichten und damit entsprechend kleinerer Elemente bei Großgruppenintegration wird jedoch bald ein Punkt erreicht, bei dem die genannten Ätzverfahren zum Bereitstellen von Dünnfilmmustern nicht weiter praktikabel sind, um die hiermit einhergehende Feinstauflösung im Metallisierungsmuster mit Linienbreiten in der Größenordnung von 2 µm oder weniger erzielen zu können.

Ein Alternativverfahren zur Bereitstellung eines derartigen Metallisierungs-Feinstrukturmusters ist unter der Bezeichnung « Verfahren mit verlorener Maske », « Abzieh- oder Schablonenverfahren » bekannt geworden. Die US-Patentschrift 3 873 361 zeigt ein derartiges Abziehverfahren zum Niederschlagen von Dünnfilmen unter Vermeidung von Kanteneinrissen. Dieses Verfahren ist jedoch nur dann geeignet, wenn die seitlichen Abstandsbreiten zwischen niedergeschlagenen benachbarten metallischen Leitungszügen in der Größenordnung von 1,3 bis 6,4 µm liegen. Das hiermit offenbarte Verfahren selbst schließt die Anwendung eines organischen polymeren Materials ein, das auf ein, eine monolithisch integrierte Halbleiterschaltung aufweisendes Substrat niedergeschlagen wird, um hierauf eine anorganische Schicht, vorzugsweise bestehend aus Metall, aufzubringen, in der Öffnungen bzw. Ausnehmungen gemäß einem vorgegebenen Muster eingebracht werden. Entsprechend diesen Öffnungen bzw. Ausnehmungen werden dann unter Verwendung dieser metallischen Maske als Abdeckung mittels reaktiver Zerstäubungsätzung in die organische polymere Schicht ebenfalls Öffnungen bzw. Ausnehmungen eingebracht. Die so in die organische polymere Schicht eingebrachten Öffnungen bzw. Ausnehmungen sind zwar mit den entsprechenden Öffnungen bzw. Ausnehmungen in der metallischen Maskenschicht ausgerichtet als unausweichliche Folge der reaktiven Zerstäubungsätzung, jedoch demgegenüber etwas ausgedehnter bzw. weiter. Mit anderen Worten, die Öffnungs- bzw. Ausnehmungsränder in der metallischen Maskenschicht weisen Überhänge bezüglich der Ränder der Öffnungen bzw. Ausnehmungen in der darunterliegenden polymeren Schicht auf. Der niederzuschlagende Dünnfilm wird dann über die so gebildete Maskenstruktur auf die freigelegten Oberflächenbereiche des Substrats aufgebracht. Wird schließend das organische polymere Material unter Anwenden eines entsprechenden Lösungsmittels beseitigt, dann hebt sich die metallische Maskenschicht sowie der Dünnfilm in den Bereichen oberhalb der zuvor vorhandenen Maskenschicht ab, so daß auf dem Substrat gemäß dem vorgegebenen Muster Dünnfilmbestände verbleiben, die keinerlei beim Abheben der unerwünschten Dünnschichtbereiche sonst zu erwartenden Kanteneinrisse zeigen.

Bei einem solchen, unter Verwendung einer metallischen Zerstäubungsätzmaske stattfindenden Prozeß ist natürlich das Ausrichten der zum Einbringen der Öffnungen bzw. Ausnehmungen in den Maskenschichten dienenden Ätzmasken äußerst schwierig, da diese Metallätzmasken undurchsichtig sind. Die betreffende Maskenausrichtungsprozedur ließe sich allerdings erleichtern, wenn entsprechende Substratbereiche für Ausrichtungsmarken an gegenüberliegenden Enden des Halbleitersubstrats vorgesehen werden, die selbst aber während des Metallmaskenniederschlagsvorgangs gegen eine Metallisierung abgedeckt sind. Das hieße aber andererseits, daß die Ausrichtungsmarkenbereiche auf dem Halbleitersubstrat für das Einbringen von aktiven oder passiven Oberflächenkomponenten als verloren angesehen sind, so daß hierdurch entsprechend die Aufnahmefähigkeit einer Waferoberfläche für integrierte Schaltungsanteile herabgesetzt wird. Außerdem erfordert die Anwendung einer derartigen Zerstäubungsätzmaske, bestehend aus reaktiv aufgedampftem Metall, die Benutzung relativ aufwendiger Verdampfungsverfahrensschritte mit nachfolgend chemischem Ätzverfahrensschritt, um die aufgedampfte Metallschicht mit dem gewünschten Muster zu versehen.

Um die mit Verwendung einer derartigen metallischen Ätzmaske verbundenen Schwierigkeiten, mindestens bis zu einem gewissen Grade zu beheben, ist ein Verfahren bereitgestellt worden, bei dem die metallische Maskenschicht durch eine transparente Schicht, bestehend aus Polydimethylsiloxanharz, ersetzt ist, so daß optische Ausrichtungsverfahren leicht anwendbar sind, also keine besonderen Ausrichtungsmarkenbereiche auf der Substratoberfläche vorgesehen zu werden brauchen. Ein derartiges Verfahren findet sich in der US-Patentschrift 4 004 044. Im Prinzip wird bei Anwenden dieses Verfahrens die als Ersatz für die Metallmaskenschicht dienende Polydimethylsiloxanharzschicht über die erste organische polymere Maskenschicht durch Rotation aufgeschleudert. Im übrigen finden dann gleiche Verfahrensschritte wie beim zuvor erwähnten Verfahren gemäß US-Patentschrift 3 873 361 Anwendung.

Somit ist es also, wie gesagt möglich, optische Maskenausrichtung anzuwenden, so daß die Notwendigkeit zur Bereitstellung besonderer Ausrichtungsmarkenbereiche auf dem Substrat entfällt und damit der brauchbare Substratbereich entsprechend erhöht wird. Zudem zeigt sich, daß die Anwendung eines derartigen durchsichtigen Maskenmaterials unter Fertigungsbedingungen zuverlässig und relativ einfach ist. Es hat sich jedoch herausgestellt, daß beim Anstreben noch weiter gehender Auflösung als sie bisher praktiziert wird, die Anwendung eines solchen Polydimethylsiloxanharzes als Maskenmaterial den gestellten Anforderungen in keiner Weise mehr genügen kann.

Um eine derartige Feinstauflösung mit Metallisierungslinienbreiten von z. B. weniger als 2 μm Breite und gegenseitigem Abstand von höchstens 1 μm zu erreichen, muß dementsprechend auch der « Prozeßüberhang » eine Reduktion gegenüber dem sich bei Verwendung des Polydimethylsiloxanharzes ergebenden erfahren. Der « Prozeßüberhang » beim in oben zitierten Patenten beschriebenen Abhebevorgangs ist definiert als Differenz zwischen den Abmessungen der entwickelten Abbildung (nämlich den Öffnungsbzw. Ausnehmungsdimensionen, die direkt über die photolithographische Maske in der oberen oder zweiten Maskenschicht auftreten) und den Dimensionen des beim abschließenden Verfahrensschritt nach Beseitigung der Maskenschichten bereitgestellten Metallfilmmusters. Zur Erzielung eines minimalen Prozeßüberhanges ist es wünschenswert, daß die Ätzrate der mittleren Schichtlage sehr viel geringer ist als die Ätzraten bei der ersten und zweiten Maskenschicht, bestehend aus Photolack, für die bei den reaktiven Ionenätzverfahrensschritten der ersten und zweiten Schicht verwendeten Ätzmittel ; wohingegen die Ätzrate für die Mittelschichtlage sehr viel höher sein sollte als die Ätzraten für die erste und zweite Schicht bei den im reaktiven Ionenätzen der Mittelschichtlage verwandten Ätzmittel. Außerdem ist es zur Erzielung minimalen Prozeßüberhangs wünschenswert, daß die Mittelschichtlage formengleich ist, nämlich daß die Dicke der Mittelschichtlage immer gleich bleibt, unbeachtlich der Oberflächengestaltung der darunterliegenden Schicht.

Polydimethylsiloxanharz besitzt unglücklicherweise eine relativ niedrige Ätzrate, selbst bei bevorzugt angewendetem Gasentladungsätzen mit Tetrafluorkohlenstoff. Für ein derartiges Ätzmittel zeigt sich tatsächlich etwa die gleiche Ätzrate, wie sie sich für die Abbildungsbemusterung der Photolackschicht ergibt. Mit anderen Worten, wenn gemäß dem oben beschriebenen bekannten Verfahren die Polydimethylsiloxanharzschicht geätzt wird, dann wird unvermeidlich gleichzeitig die in der oberen zweiten Maskenschicht eingebrachte Öffnung bzw. Ausnehmung ebenfalls angegriffen, so daß die sich tatsächlich ergebenden Abmessungen im metallischen Dünnfilm wesentlich von den beabsichtigten Abmessungen mit der ursprünglichen photolithographischen Maske abweichen. Selbst wenn die Abmessungen in der photolithographischen Maske durch Kompensation der relativ geringeren Ätzrate der Polydimethylsiloxanharzschicht entsprechend herabgesetzt werden, ist es nicht möglich, eine Metallschicht mit hierin enthaltenen, sehr genauen Dimensionen bereitzustellen, da diese Dimensionen dann abweichend von den durch die photolithographischen Maske vorgegebenen Dimensionen eine Funktion der Prozeßvariablen darstellen würden ; wobei die Ätzvariablen durch Ätzzeitdauer, Dicke der Polydimethylsiloxanharzschicht Substratoberflächengestaltung und Temperatur vorgehen sind. Hinzu kommt, daß, da die Polydimethylsiloxanharzschicht unter Anwenden eines Schleuderverfahrens niedergeschlagen werden muß, diese zwangsläufig ungleichförmig und somit in einer Dicke aufgetragen werden muß, die sehr stark von der Substratoberflächengestaltung abhängig ist. So kann z. B. im Bereich einer Durchbohrung im Substrat die Dicke der Polydimethylsiloxanharzschicht mehr als doppelt so stark sein, als in ebenen Substratbereichen.

Bei dieser Sachlage besteht die Aufgabe der Erfindung darin, ein einrißfreies Leitungszugsmuster in Dünnfilmtechnik in feinster Auflösung, also mit Linienbreiten und Linienabständen in der Größenordnung von 1 μm, auf ein Substrat, ohne Zuhilfenahme besonderer, auf dem Substrat aufgebrachter Ausrichtungsmarken für die anzuwendenden Maskenverfahren aufzubringen.

Diese Aufgabe wird gemäß der Erfindung gelöst, wie es dem Kennzeichen des Anspruchs 1 zu entnehmen ist.

Die dank der Erfindung zu erzielenden Vorteile liegen darin, daß sich die verschiedenen Maskenschichten mit gleichförmiger Dicke auftragen lassen, indem sich die Ätzraten der verschiedenen Schichten hinreichend genau steuern lassen ; wobei auch die Dimensionen des niedergeschlagenen metallischen Dünnfilms als Leitungszugsmuster ebenso genau mit Hilfe des anzuwendenden photolithographischen Maskenverfahrens aufzubringen sind. Ein wesentlicher Vorteil ergibt sich noch daraus, daß bei Anwenden des erfindungsgemäßen Verfahrens die Erfordernis entfällt, besondere Flächenbereiche auf dem Substrat für Ausrichtungsmarken bereitzustellen, so daß dadurch kein wertvoller Platz für Schaltungskomponenten der aufzubringenden monolithisch integrierten Halbleiterschaltung verloren gehen kann.

Zur Durchführung des Verfahrens gemäß der Erfindung wird ein Substrat zunächst mit einer ersten Maskenschicht bedeckt, die vorzugsweise aus organischem polymeren Material, wie Photolack, bestehen kann, der in einen nicht-lichtempfindlichen Zustand gebracht werden kann. Um die Haftungsfähigkeit dieser Maskenschicht zu begünstigen, läßt sie sich noch anbacken. Auf die so aufgetragene erste Maskenschicht wird dann eine Schicht, bestehend aus Siliciumnitrid, aufgebracht. Mit Hilfe üblicher photolithographischer oder Ionenätzverfahren werden dann Öffnungen bzw. Ausnehmungen in die Siliciumnitridschicht eingebracht. Hierzu läßt sich z. B. die Siliciumnitridschicht mit einer zweiten Maskenschicht, ebenfalls bestehend aus Photolack, abdecken, die ihrerseits über eine photolithographische Maske exponiert und entwickelt wird, um aus der zweiten Maskenschicht entsprechend den in der Siliciumnitridschicht einzubringenden Öffnungen bzw. Ausnehmungen Schichtbereiche zu entfernen. Im anschließenden Verfahrensschritt wird dann die Siliciumnitridschicht über diese Öffnungen bzw. Ausnehmungen in der zweiten Maskenschicht abgeätzt, indem z. B. als reaktives Ionenätzmittel Tetrafluorkohlenstoff Anwendung findet.

Die Siliciumnitridschicht wird vorzugsweise unter Anwenden eines Gasentladungsniederschlagsverfahrens in geeigneter Atmosphäre niedergeschlagen. Als nächstes werden dann formengleiche bzw. übereinstimmende Öffnungen bzw. Ausnehmungen in die erste Maskenschicht mit Hilfe eines zweiten reaktiven Zerstäubungsätzungsverfahrensschritt in der gleichen Zerstäubungskammer, allerdings unter Anwenden einer Sauerstoffatmosphäre anstelle der bei Ätzung der Siliciumnitridschicht angewendeten Tetrafluorkohlenstoffatmosphäre, eingebracht. Ein Überätzen dieser ersten Maskenschicht hat die Bildung eines Überhangs der Siliciumnitridschicht oberhalb der Öffnung bzw. nehmung in der ersten Maskenschicht zur Folge. Über die so erhaltene, sich über dem gesamten Substrat ergebende Oberfläche wird dann ein metallischer Dünnfilm aufgebracht, der sich demgemäß sowohl auf die in den Öffnungen bzw. Ausnehmungen in der Siliciumnitridschicht und der ersten Maskenschicht freiliegenden Substratoberflächenbereiche als auch auf die abdeckenden Schichtbereiche des Substrats niederschlägt. Dieser Überhang der Siliciumnitridschicht verhindert, daß der sich auf das Substrat niederschlagende metallische Dünnfilm mit dem verbleibenden Teil des niedergeschlagenen metallischen Dünnfilms oberhalb der äußeren Oberfläche der Siliciumnitridschichtbereiche in Kontakt geraten kann bzw. hiermit eine Verbindung eingeht.

Die zuunterst liegende erste Maskenschicht wird anschließend chemisch abgelöst, indem gleichzeitig die Siliciumnitridschicht und unerwünschte Bereiche des niedergeschlagenen metallischen Dünnfilms beseitigt werden, so daß dann der metallische Dünnfilm auf dem Substrat in gewünschtem Muster aufgebracht ist.

Da somit dank der Erfindung keine mechanische Verbindung zwischen dem metallischen Dünnfilmbereich, der auf dem Substrat selbst niedergeschlagen ist, und dem metallischen Dünnfilmbereich, wie er auf den abdeckenden Schichten aufgebracht ist, besteht, können auch beim Entfernen der nicht benötigten Maskenschichtbereiche und der übrigen unerwünschten metallischen Dünnfilmschichtbereiche keine Kanteneinreißungseffekte im auf dem Substrat aufgebrachten Dünnfilmmuster auftreten.

Vorteilhafte Ausgestaltung und Weiterbildungen der Erfindung lassen sich den Unteransprüchen entnehmen.

Die Erfindung wird nachstehend anhand einer Ausführungsbeispielsbeschreibung mit Hilfe der unten aufgeführten Zeichnungen näher erläutert. Es zeigen :

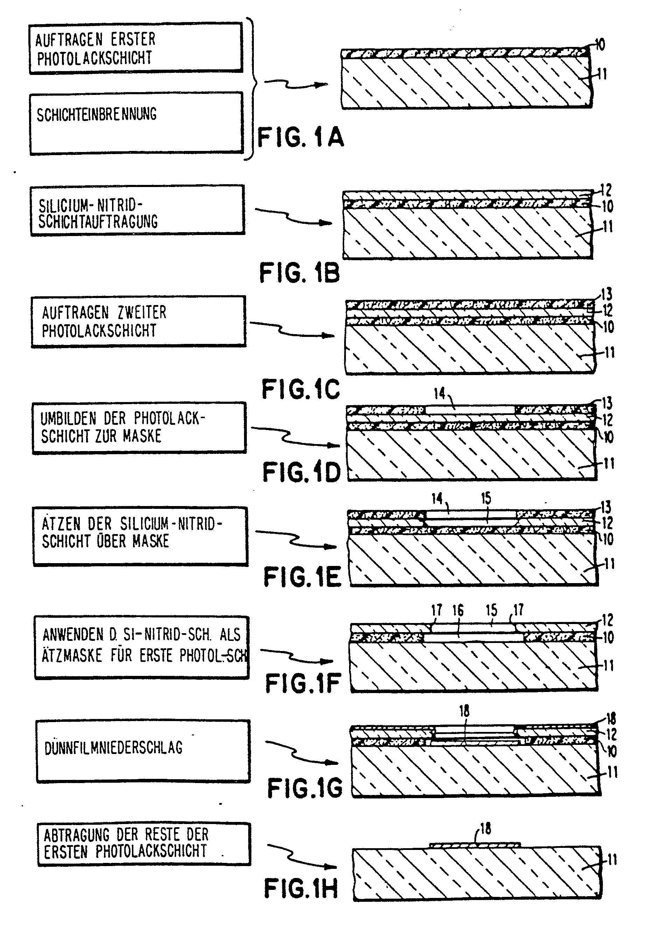

Figur 1A bis 1H Ausschnittsquerschnitte einer monolithisch integrierten Halbleiterstruktur in den verschiedenen Stadien beim erfindungsgemäß angewendeten Herstellungsverfahren unter gleichzeitiger Bezeichnung des jeweiligen Verfahrensschrittes.

Gemäß Fig. 1A ist zunächst auf ein Substrat 11 eine erste Photolackschicht 10, bestehend aus einem organischen polymeren Material aufgebracht. Das organische polymere Material kann aus einem Phenolformaldehydharz in Verbindung mit einem photoempfindlichen Querverbindungsagens (AZ-1 350-Polymer der Firma . Shipley Corporation) bestehen, welches unter Aufheizen auf etwa 210 °C zur Haftungsverbesserung mit dem Substrat 11 eingebrannt wird. Durch diesen Einbrennvorgang wird außerdem die Schicht thermisch stabilisiert und nichtlichtempfindlich gemacht, so daß sie bei Anwenden des Photoprozesses auf die zweite Photolackschicht nicht beeinflußt werden kann. Die Dicke der ersten Photolackschicht 10 legt die maximale Dicke des auf das Substrat 11 niederzuschlagenden metallischen Dünnfilms fest, der ja gemäß der Erfindung ohne Kanteneinrisse während des darauffolgenden Abhebevorgangs bleibt. Bei Anwenden des erfindungsgemäßen Verfahrens auf die Herstellung von monolithisch integrierten Halbleiterschaltungen kann das Substrat 11 aus einem Halbleiter oder einem Halbleitersubstrat bestehen, dessen Oberflächenschicht aus einem elektrisch isolierendem anorganischen Material, wie z. B. Siliciumdioxid, gebildet wird. Die erste Photolackschicht 10 kann aus irgendeinem, für den Überzug von Substraten geeigneten polymeren Material bestehen, das gute Haftungseigenschaften für das betreffende Substrat 11 aufweisen muß, ebenso wie für hierauf aufzutragendes Siliciumnitrid. Zudem sind eine gewisse thermische Stabilität und Abtragungsfähigkeit unter Einwirkung eines reaktiven Ätzzerstäubungsvorgangs erforderlich. Allen diesen Anforderungen genügt das oben angegebene Material der Firma Shipley Corporation. Wird die Photolackschicht 10 bei etwa 210 °C zur Haftungsverbesserung mit dem darunterliegenden Substrat 11 eingebrannt, dann wird, wie gesagt, der Photolack thermisch stabilisiert und gleichzeitig lichtunempfindlich gemacht. Der Lichtempfindlichkeitsverlust stellt keinen Nachteil dar, da die erste Photolackschicht 10 in ausgewählten Bereichen durch reaktives Ionenätzen abgetragen wird. Anderes geeignetes Photolackmaterial können KTFR von der Firma Kodak Corporation, synthetisches Harz, wie z. B. Polyvinylcinnamat, Polymethylmethacrylat, ebenso wie Diazo-Photolack und Polyimide neben vielen anderen sein.

Wie in Fig. 1B angedeutet, wird eine zweite Schicht auf die erste Photolackschicht 10 aufgebracht. Diese zweite Schicht besteht aus einer Siliciumnitridschicht 12, die unter Anwenden von Gasentladungsniederschlagsverfahren aufgebracht wird und deren Anwendung übliche Aufdampfungsfehler, speziell unebene bzw. ungleichmäßige Ablagerung, vermeidet. Ganz allgemein läßt sich sagen, daß durch Anwenden des Gasentladungsniederschlagsverfahrens sich ein gleichförmiger Überzug in Gestalt der Siliciumnitridschicht 12 auf die äußere Oberfläche der ersten Photolackschicht 10 auftragen läßt. Mit anderen Worten, die Dicke der Siliciumnitridschicht 12 ist über dem ganzen Oberflächenbereich konstant und im wesentlichen unabhängig von der Topographie der darunterliegenden ersten Photolackschicht 10 und infolgedessen auch der Substrattopographie einschließlich der hierin enthaltenen monolithisch integrierten Halbleiterschaltung. Unter Anwenden des letztgenannten Verfahrens ergibt sich zudem, daß die aufgebrachte Siliciumnitridschicht 12 durchsichtig ist, womit sich erfindungsgemäß noch der Vorteil einstellt, daß das Anwenden eines optischen Ausrichtungsvorgangs für die photolithographischen Masken ohne Zuhilfenahme spezieller Ausrichtungsmarken ermöglicht wird. Im bevorzugten Ausführungsbeispiel des erfindungsgemäßen Verfahrens reicht eine Dicke der Siliciumnitridschicht 12 im Bereich von 150 bis 160 nm zum Herbeiführen der gewünschten Wirkung völlig aus, obgleich auch andere Dickenwerte ebensogut vorgesehen werden können, je nach im einzelnen vorzunehmender Behandlung.

Unter Bezugnahme auf die Ansichten in Fig. 1C und 1D wird zunächst eine Photo- oder Elektronenstrahllackschicht 13 auf die Siliciumnitridschicht 12 in einem Aufschleudervorgang aufgebracht. Zur Vorbehandlung der Siliciumnitridschicht 12 vor Aufbringen der Photo- oder Elektronenstrahllackschicht 13 kann Hexamethyldisilazan oder A-1 100 Silan (beides erhältlich von der Union Carbide Corporation) Verwendung finden. Öffnungen bzw. Ausnehmungen 14 in dieser Photo- oder Elektronenstrahllackschicht 13 lassen sich mit Hilfe üblicher lithographischer Verfahren, wie sie an sich bei Herstellung von monolithisch integrierten Halbleiterschaltungen bekannt sind, einbringen. Es wird jedoch hervorgehoben, daß die Siliciumnitridschicht transparent ist, so daß sich optische Ausrichtungsmöglichkeiten für die auf die gemusterte Oberfläche des Substrats 11 anzuwendenden photolithographischen Masken benutzen lassen. Speziell sei darauf hingewiesen, daß dank Anwendung des erfindungsgemäßen Verfahrens keine besonderen Ausrichtungsmarken auf dem Substrat erforderlich sind, die verständlicherweise sonst die zur Verfügung stehenden Oberflächenbereiche auf Substrat 11 entsprechend einschränken würden ; wie es z. B. der Fall wäre, wenn die zweite Schicht 12 wie sonst üblich aus einem undurchsichtigen Material bestehen würde.

Die exponierte und gemusterte zweite Photolackschicht 13 wird dann ihrerseits als Maske für das reaktive Ionenätzen der darunterliegenden Siliciumnitridschicht 12, wie in Fig. 1E angedeutet, herangezogen. Hierzu wird die in Fig. 1E dargestellte Struktur in eine Hochfrequenz-Zerstäubungsätzkammer, wie sie z. B. in der US-Patentschrift 35 98 710 beschrieben ist, eingebracht. Die Siliciumnitridschicht 12 wird vorzugsweise in einem DE 100-Gas, geliefert von der LFE-Corporation, geätzt, wobei letzgenanntes Gas aus Tetrafluorkohlenstoff und Sauerstoff besteht. Auf diese Weise wird die jeweilige Öffnung- bzw. Ausnehmung 14 in der zweiten Photolackschicht 13 als Öffnung bzw. Ausnehmung 15 in die Siliciumnitridschicht 12 übertragen. Da jedoch die Ätzrate der Siliciumnitridschicht 12 sehr viel höher ist als die der zweiten Photolackschicht 13, bleiben bei Anwenden dieses Ätzmittels die Abmessungen der Öffnung bzw. Ausnehmung 14 im wesentlichen unverändert beibehalten. Anschließend wird dann die zweite Photolackschicht 13 mit Hilfe einer geeigneten Lösung abgetragen.

Unter Verwendung der Siliciumnitridschicht 12 mit eingebrachter Öffnung bzw. Ausnehmung 15 als Maske wird dann unter Anwenden eines reaktiven Ionenätzverfahrens in Sauerstoffgasatmosphäre eine entsprechende Öffnung in die erste Photolackschicht 10 eingebracht. Die anwendbaren Parameter für die Sauerstoffgasentladung bestimmen sich durch die gewünschten Abmessungen des Überhangs 17 an der Öffnung bzw. Ausnehmung 15 in der Siliciumnitridschicht 12 gegenüber der Öffnung bzw. Ausnehmung 16, die in die erste Photolackschicht 10 mittels Zerstäubungsätzung eingebracht ist. So läßt sich z. B. ein gewisser Überhang bei einer Sauerstoffatmosphäre unter 53 mbar Druck erzielen, wohingegen im wesentlichen kein Überhang entsteht, wenn der Ätzvorgang bei einem Sauerstoffdruck von etwa 5 mbar durchgeführt wird. Es wird hervorgehoben, daß, da die Siliciumnitridschicht im wesentlichen für den Sauerstoffätzungsvorgang undurchdringlich ist, die Dimensionen der Öffnung bzw. Ausnehmung 15 im wesentlichen während dieses Verfahrensschrittes beibehalten bleiben, so daß die Abmessungen des anschließend aufzutragenden Dünnfilms sehr genau durch die Abmessungen der Öffnung bzw. Ausnehmung 14 festgelegt sind.

Die anschließenden reaktiven Ionenzerstäubungsätzverfahrensschritte, die im Zusammenhang mit den Fign. 1E und 1F zu beschreiben sind, werden üblicherweise in der gleichen Zerstäubungsätzungskammer vorgenommen, indem zunächst eine Atmosphäre aus einem, eine Fluorverbindung enthaltenden Gas und zwar im Fall der Fig. 1E angewendet wird, gefolgt durch die Behandlung in einer Sauerstoffgasatmosphäre, wie es für den Fall der Fig. 1F gilt.

Dank des Überhangs 17 in der Siliciumnitridschicht 12 läßt sich ein beträchtliches Überätzen der organischen Polymerschicht 10 vornehmen, um zu gewährleisten, daß das gesamte Material der organischen Polymerschicht 10 an den Stellen der gewünschten Öffnung bzw. Ausnehmung 16 beseitigt ist. Die Musterungsabmessungen im auf das Substrat 11 über die Öffnung bzw. Ausnehmungen 15 und 16 aufzutragenden funktionalen Dünnfilm bestimmen sich nach der jeweiligen Öffnungsabmessung in den Überhängen in der Schicht 12 und nicht durch die größeren Öffnungsabmessungen in der darunterliegenden Schicht 10. Wie bereits erwähnt, unterstützt der jeweilige Überhang 17 das Nichtauftreten von Kanteneinreißungen, wenn das überschüssige Dünnfilmmaterial in den dem vorliegenden Prozeßschritt nachfolgenden Prozeßschritten abgehoben werden soll. Auf die so erhaltene Struktur, wie sie sich aus Fig. 1F ergibt, wird nun ein metallischer Dünnfilm 18 niedergeschlagen, so daß sich die in Fig. 1G gezeigte Struktur ergibt. Das Material dieses metallischen Dünnfilms 18 kann irgendeines der für integrierte Schaltungsmetallisierung üblicherweise verwendeten Metalle, wie z. B. Aluminium, Aluminiumkupferlegierung, Platin, Palladium, Chrom und dgl., sein. Der metallische Dünnfilm 18 wird oberhalb der Raumtemperatur bei etwa 150 °C niedergeschlagen. Alternativ hierzu kann der Dünnfilm 18 auch aus einem anorganischen, elektrisch isolierenden Material, wie z. B. Siliciumdioxid oder Siliciumnitrid, bestehen. In jedem Falle besitzt der Dünnfilm 18 eine bevorzugte Dicke in der Größenordnung von 1,5 µm bis 2,5 µm.

Unter Anwenden von üblichen Filmabhebeverfahren schließlich wird die Photolackschicht 10 durch Eintauchen in eine entsprechende Lösung, wie z. B. N-Methylpyrrolidon, einer gebräuchlichen Photolacklösung während einer Zeitdauer von 15 bis 30 Minuten vollständig entfernt, so daß der Dünnfilm 18 nunmehr in der gewünschten Musterung auf dem Substrat 11 vorliegt, wie in Fig. 1H angedeutet. Die hierbei verwendete Lösung sollte derart sein, daß hierdurch zwar das organische Polymermaterial der Photolackschicht 10 aufgelöst oder aufgequollen wird, jedoch der Dünnfilm 18 hierdurch im wesentlichen unbeeinflußt bleibt. Derartige Lösungen können sein : Aceton, Isopropanol, Methylethyl, Keton oder Trichloräthylen. Die zur Auflösung des organischen Polymermaterials verwendeten Lösungen können die gleichen Lösungen sein, wie sie zum Auftragen der Photolackschicht 10 Anwendung gefunden haben. Falls eine zweite Metallisierungsebene angebracht werden soll, wird zunächst eine hier nicht gezeigte Siliciumdioxidschicht über die in Fig. 1H dargestellte Struktur aufgebracht, um dann die Prozeßverfahrensschritte gemäß den Fign. 1A bis 1H zu wiederholen mit dem Ziel, einen zweiten gemusterten metallischen Dünnfilm anzubringen, der elektrisch isoliert vom ersten Dünnfilmmuster 18 aufgebracht ist. Im übrigen ist die Siliciumnitridschicht 12 gegenüber dem Ätzen mittels Argonionenzerstäubung wiederstandsfähig bzw. unempfindlich, welch letzteres angewendet wird, um die erste Metallisierung über in die isolierende Oxidschicht eingebrachte Löcher zu säubern.

**Ansprüche**

1. Verfahren zum Aufbringen eines gemäß einem vorgegebenen Muster ausgelegten Dünnfilms (18) auf ein Substrat (11) unter Anwenden folgender Verfahrensschritte : Auftragen einer ersten, aus organischem polymeren Material bestehenden Photolackschicht (10) auf das Substrat (11), Abdecken dieser ersten Photolackschicht (10) durch eine in ausgewählten Bereichen mit Öffnungen (15) versehene, aus einer Siliciumverbindung bestehende Schicht (12), Einbringen von bis an die Substratoberfläche reichenden Öffnungen (16) in die erste Photolackschicht (10) mit Hilfe eines Zerstäubungsätzungsverfahrens, wobei die in die erste Photolackschicht (10) eingebrachten Öffnungen (16) zwar mit den Öffnungen (15) in der darüberliegenden Siliciumnitridschicht (12) fluchten, jedoch seitlich größere Abmessungen aufweisen, so daß die Öffnungsberandungen (17) der Siliciumnitridschicht (12) überhängen, Niederschlagen eines Dünnfilms (18), sowohl auf die freigelegten Substratbereiche als auch auf die verbliebenen Bereiche der Siliciumnitridschicht (12), Entfernen der verbliebenen Bereiche der ersten Photolackschicht (10), dadurch gekennzeichnet, daß das Abdecken der ersten Photolackschicht (10) mittels Siliciumnitrid durch Gasentladungsniederschlag von Material aus der Gasphase erfolgt, daß die Öffnungen (15) in die so gebildete Siliciumnitridschicht (12) über eine in an sich bekannter Weise anschließend aufgebrachte Maskenschicht (13) durch reaktives Ionen-Zerstaubungs-Ätzen in Tetrafluorkohlenstoffentladungsgas eingebracht werden, daß die Öffnungen (16) in die erste Photolackschicht (10) durch reaktives Ionen-Zerstäubungs-Ätzen in Sauerstoffentladungsgas eingebracht werden, und daß die Reste der ersten Photolackschicht (10) durch Eintauchen in eine Lösung, bestehend aus N-Methylpyrrolidon, Aceton, Isopropanol, Methylethyl, Keton oder Trichloräthylen entfernt werden.

2. Verfahren nach Anspruch 1, dadurch gekennzeichnet, daß ein metallischer Dünnfilm in einer Dicke von 1,5 bis 2,5 µm niedergeschlagen wird.

3. Verfahren nach Anspruch 1 und Anspruch 2, dadurch gekennzeichnet, daß die reaktiven Ionen-Zerstäubungs-Ätzverfahrensschritte aufeinanderfolgend in derselben Zerstäubungskammer durchgeführt werden.

4. Verfahren nach Anspruch 1, dadurch gekennzeichnet, daß als Maskenschicht (13) eine zweite Photolackschicht aufgetragen wird.

5. Verfahren nach Anspruch 1, dadurch gekennzeichnet, daß als Maskenschicht (13) eine elektronenstrahlempfindliche Lackschicht aufgetragen wird.

6. Verfahren nach den Ansprüchen 1 bis 5, dadurch gekennzeichnet, daß vor dem Dünnfilmniederschlag die in der Siliciumnitridschicht (12) durch die Öffnungen (15) freigelegten Substratbereiche einem Reinigungsverfahrensschritt unter Anwendung von Argonionen-Zerstäubung unterzogen werden.

7. Verfahren nach den Ansprüchen 1 bis 6, gekennzeichnet durch Bereitstellung einer zweiten Metallisierungsebene auf dem zuvor in an sich bekannter Weise mit einer Isolierschicht überzogenen, die aufgebrachte erste Metallisierungsebene tragenden Substrat (12).

## Claims

1. Method of applying a thin film (18) in accordance with a predetermined pattern on a substrate (10) comprising the following process steps : applying a first photoresist layer (10) of an organic polymeric material on the substrate (11), covering this first photoresist layer (10) with a layer (12) consisting of a silicon compound having openings (15) in predetermined regions, providing apertures (16) reaching up to the substrate surface in the first photoresist layer (10) by means of a sputter etching process, the apertures (16) in the first photoresist layer (10) being flush with the openings (15) in the superimposed silicon nitride layer (12), but having bigger lateral dimensions so that the edges (17) of the apertures in the silicon nitride layer (12) are overhanging, depositing a thin film (18) on the exposed substrate regions as well as on the remaining silicon nitride layer (12) regions, removing the remaining regions of the first photoresist layer (10), characterized in that the covering of the first photoresist layer (10) with silicon nitride is effected through plasma deposition of material out of the gaseous phase, that the apertures (15) are made in the thus formed silicon nitride layer (12) over a mask layer (13) subsequently applied in a manner known per se through reactive ion etching in tetrafluorocarbon discharge gas, that the apertures (16) are made in the first photoresist layer (10) through reactive ion etching in oxygen discharge gas, and that the residues of the first photoresist layer (10) are removed by immersion in a solution consisting of N-methylpyrrolidone, acetone, isopropanol, methyl ethyl, ketone, or trichloroethylene.

2. Method as claimed in claim 1, characterized in that a metallic thin film in a thickness of 1.5 to 2.5 μm is deposited.

3. Method as claimed in any one of claims 1 and 2, characterized in that the reactive ion sputtering etching steps are implemented successively in the same sputtering chamber.

4. Method as claimed in claim 1, characterized in that as a mask layer (13) a second photoresist layer is applied.

5. Method as claimed in claim 1, characterized in that as a mask layer (13) an electron beam-sensitive resist layer is applied.

6. Method as claimed in any one of claims 1 to 5, characterized in that prior to the thin film deposition the substrate regions exposed in the silicon nitride layer (12) through the apertures (15) are subjected to a cleaning process using argon ion sputtering.

7. Method as claimed in any one of claims 1 to 6, characterized by providing a second metallization plane on the substrate (12) which previously had been coated with an insulating layer in a manner known per se and which supports the deposited first metallization plane.

## Revendications

1. Procédé pour appliquer un film mince (18) réalisé selon un patron prédéterminé sur un substrat (11) avec application des phases de procédé suivantes : application d'une première couche de laque photosensible (10) composée d'une matière polymère organique sur le substrat (11) ; recouvrement de cette première couche de laque photosensible (10) au moyen d'une couche (12) constituée par un composé du silicium et munie d'ouvertures (15) dans des régions choisies ; formation d'ouvertures (16) se prolongeant jusqu'à la surface du substrat dans la première couche de laque photosensible (10) à l'aide d'un procédé d'attaque par pulvérisation, les ouvertures (16) ménagées dans la première couche de laque photosensible (10) coïncidant certes avec les ouvertures (15) formées dans la couche de nitrure de silicium (12) sous-jacentes mais présentant latéralement des dimensions plus grandes, de sorte que les bords (17) des ouvertures de la couche de nitrure de silicium (12) surplombent ; dépôt d'un film mince (18) aussi bien sur les régions exposées du substrat que sur les régions subsistantes de la couche de nitrure de silicium (12) ; enlèvement des régions restantes de la première couche de laque photosensible (10), caractérisé en ce que le recouvrement de la première couche de laque photosensible (10) au moyen de nitrure de silicium s'effectue par dépôt d'une matière issue d'une phase gazeuse par décharge dans un gaz, en ce que les ouvertures (15) ménagées dans la couche ·de nitrure de silicium (12) ainsi formée sont formées à travers une couche de masque (13) déposée ensuite d'une façon connue, par attaque par pulvérisation d'ions réactifs dans un gaz de décharge composé de tétrafluorure de carbone, en ce que les ouvertures (16) sont formées dans la première couche de laque photosensible (10) par attaque par pulvérisation d'ions réactifs dans un gaz de décharge à base d'oxygène, et en ce qu'on élimine les restes de la première couche de laque photosensible (10) par immersion dans une solution composée de N-méthylpyrrolidone, d'acétone, d'isopropanol, de méthyléthylcétone ou de trichloréthylène.

2. Procédé selon la revendication 1, caractérisé en ce qu'on dépose un film métallique mince en une épaisseur de 1,5 à 2,5 μm.

3. Procédé selon la revendication 1 et la revendication 2, caractérisé en ce que les phases du procédé d'attaque par pulvérisation d'ions réactifs sont exécutées l'une à la suite de l'autre dans la même chambre de pulvérisation.

4. Procédé selon la revendication 1, caractérisé en ce qu'on dépose comme couche de masque (13) une deuxième couche de laque photosensible.

5. Procédé selon la revendication 1, caractérisé en ce qu'on dépose comme couche de masque (13) une couche de laque sensible aux faisceaux d'électrons.

6. Procédé selon les revendications 1 à 5, caractérisé en ce que, avant le dépôt du film mince, on soumet les régions du substrat mises à nu dans la couche de nitrure de silicium (12) à travers les ouvertures (15) à une phase de procédé de nettoyage avec application de la pulvérisation d'ions argon.

7. Procédé selon les revendications 1 à 6, caractérisé en ce qu'on prépare un deuxième plan de métallisation sur le substrat (12) portant le premier plan de métallisation déposé et précédemment revêtu d'une couche isolante d'une façon connue en soi.

AUFTRAGEN ERSTER PHOTOLACKSCHICHT

SCHICHTEINBRENNUNG

**FIG. 1A**

SILICIUM-NITRID-SCHICHTAUFTRAGUNG

**FIG. 1B**

AUFTRAGEN ZWEITER PHOTOLACKSCHICHT

**FIG. 1C**

UMBILDEN DER PHOTOLACK-SCHICHT ZUR MASKE

**FIG. 1D**

ÄTZEN DER SILICIUM-NITRID-SCHICHT ÜBER MASKE

**FIG. 1E**

ANWENDEN D. SI-NITRID-SCH. ALS ÄTZMASKE FÜR ERSTE PHOTOL.-SCH

**FIG. 1F**

DÜNNFILMNIEDERSCHLAG

**FIG. 1G**

ABTRAGUNG DER RESTE DER ERSTEN PHOTOLACKSCHICHT

**FIG. 1H**